# EUROPEAN PATENT APPLICATION

(11) **EP 2 581 950 A2**
(43) Date of publication of application: **17.04.2013**
(21) Application number: 12184308.0
(22) Date of filing: 13.09.2012
(51) Int. Cl.: H01L 31/18

(54) **Method of manufacturing a photoelectric device**

(30) Priority: 13.10.2011 US 201161546642 P; 07.08.2012 US 201213568462
(71) Applicant: Samsung SDI Co., Ltd., Yongin-si, Gyeonggi-do (KR)
(72) Inventor: Park, Sang-Jin, Gyeonggi-do (KR); Song, Min-Chul, Gyeonggi-do (KR); Park, Sung-Chan, Gyeonggi-do (KR); Kim, Dong-Seop, Gyeonggi-do (KR); Kim, Won-Gyun, Chungcheongnam-do, 331-300 (KR); Seo, Sang-Won, Gyeonggi-do (KR)
(74) Representative: Mounteney, Simon James

(57) **Abstract**

A method of manufacturing a photoelectric device comprising: providing a substrate; applying a first doping source material to a first surface of the substrate, so as to form a first doping material layer over the said first surface; applying a drive-in process to cause a dopant from the first doping material layer to diffuse into the substrate; and applying a second doping source material to the said first surface of the substrate, so as to form a second doping material layer over the said first doping material layer.

According to one or more embodiments of the present invention, a photoelectric device capable of reducing a contact resistance with electrodes, reducing a serial resistance of photocurrent paths, and suppressing a surface recombination loss caused by excessive increases in a junction depth and a surface concentration is provided.

## Description

### BACKGROUND

The present invention relates to a method of manufacturing a photoelectric device.

Recently, due to problems such as exhaustion of energy resources and environmental pollution of the earth, the development of clean energy sources has been accelerating. Photovoltaic energy generated using solar cells is directly transformed from sunlight and thus is regarded as such a clean energy source.

Unfortunately, the cost of generating photovoltaic energy industrially by using solar cells is high in comparison to generation of thermal energy, as a consequence of the relatively low power generation efficiency of the solar cells and this has tended to restrict the broad application of solar cells. One of the restrictions on collar cell efficiency arises from surface recombination losses. Another arises from the serial resistance of photocurrents generated by such solar cells.

The present invention sets out to overcome the above problems of the prior art.

Accordingly, a first aspect of the invention provides a method of manufacturing a photoelectric device as set out in Claim 1. Preferred features of the invention are set out in Claims 2 to 17.

According to one or more embodiments of the present invention, it is therefore possible to provide a photoelectric device that is capable of reducing a contact resistance with electrodes, reducing a serial resistance of photocurrent paths. Embodiments of the invention also make it possible to suppress a surface recombination loss that is conventionally caused by an increase in a junction depth involved with an increase in a doping level and an excessive increase in a surface concentration arising from doping a selective emitter area for forming electrode junction parts at a high concentration.

### BRIEF DESCRIPTION OF THE DRAWINGS

Embodiments of the invention will be described by way of example and with reference to the accompanying drawings, in which:
FIGS. 1 and 2 are schematic views showing the structure of a photoelectric device according to an embodiment of the present invention; and
FIGS. 3A through 3M are sequential cross-sectional views for describing a method of manufacturing a photoelectric device, according to an embodiment of the present invention.

### DETAILED DESCRIPTION

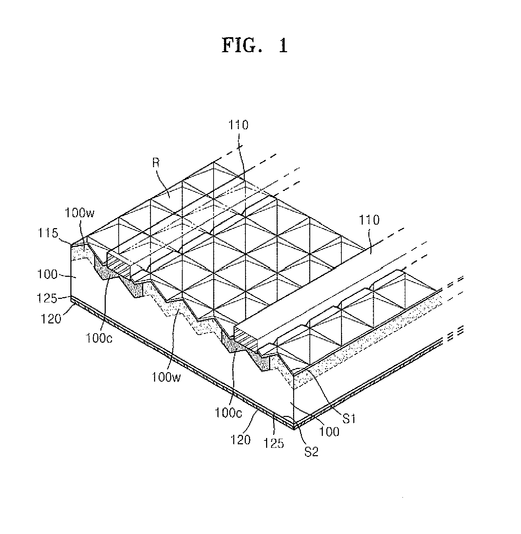

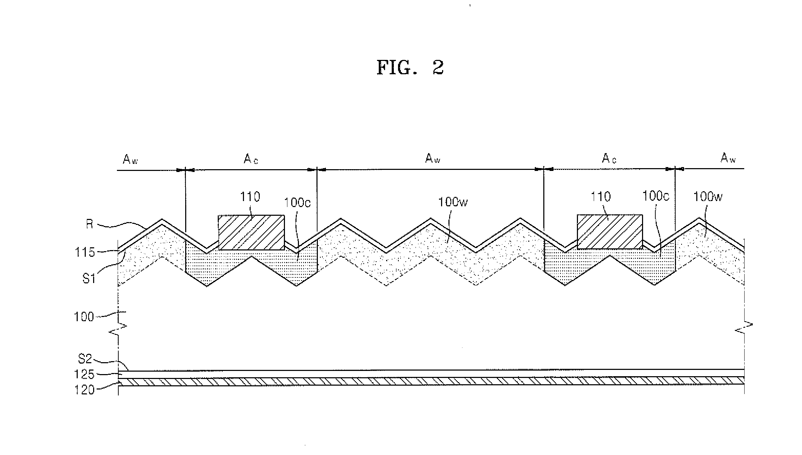

FIGS. 1 and 2 are schematic views showing the structure of a photoelectric device according to an embodiment of the present invention.

Referring to FIGS. 1 and 2, the photoelectric device includes a semiconductor substrate 100, contact layers 100c and window layers 100w alternately formed on the semiconductor substrate 100, and first electrodes 110 formed on the contact layers 100c.

The semiconductor substrate 100 has a first surface S1, and a second surface S2 opposite to the first surface S1. In this example, the first surface S1 is a light-receiving surface of the semiconductor substrate 100, and the second surface S2 is a reverse surface opposite to the light-receiving surface.

The semiconductor substrate 100 generates carriers if light is received on the first surface S1. The carriers are holes and electrons generated when light is absorbed into the semiconductor substrate 100. The semiconductor substrate 100 may be formed as, e.g., a single crystal or poly crystal silicon substrate having an n or p conductive type. For example, according to an embodiment of the present invention, the semiconductor substrate 100 may be formed as a p-type single crystal silicon substrate.

Microroughness is formed on a first surface S1 of the semiconductor substrate 100 in the form of a texture structure R including a roughness pattern. The texture structure R reduces reflectance of incident light, and increases light harvesting efficiency in order to allow the incident light to be absorbed into the semiconductor substrate 100 as much as possible.

The contact layers 100c and the window layers 100w are formed in the first surface S1 of the semiconductor substrate 100. In this example, the contact layers 100c and the window layers 100w are alternately formed along the first surface S1 of the semiconductor substrate 100. In FIG. 2, reference numerals Ac and Aw respectively represent areas where the contact layers 100c and the window layers 100w are formed.

The contact layers 100c and the window layers 100w are doped with a material having a conductivity type that is inverse to that of the semiconductor substrate 100, and thus may form p-n junction. For example, the contact layers 100c and the window layers 100w may be formed as a doping layer of which a conductivity type is inversed by injecting an n-type dopant into the p-type semiconductor substrate 100. The contact layers 100c and the window layers 100w have the same conductivity type but different doping levels. For example, the contact layers 100c may be doped at a high concentration, and the window layers 100w may be doped at a low concentration.

The contact layers 100c are areas where electrode junction parts on which the first electrodes 110 are to be disposed are selectively doped at a high concentration, and serve to form a selective emitter on which emitters for collecting minority carriers generated by the semiconductor substrate 100 are locally formed. For example, the first electrodes 110 are formed on the contact layers 100c by using a metallic material, and a contact resistance with the first electrodes 110 may be reduced by doping the electrode junction parts at a high concentration.

The window layers 100w serve to provide a valid incident surface of the semiconductor substrate 100. If light is incident on the window layers 100w, the semiconductor substrate 100 may generate carriers. A contact resistance with the first electrodes 110 may be reduced by doping at a high concentration the contact layers 100c on which the first electrodes 110 are disposed, and a surface recombination loss caused by an excessive dopant concentrated on a surface of the semiconductor substrate 100 may be reduced and a transformation efficiency with respect to short wavelengths absorbed near the surface may be increased by doping at a low concentration the window layers 100w on which the first electrodes 110 are not disposed.

The contact layers 100c and the window layers 100w may be formed by locally heating the semiconductor substrate 100 on which a doping material layer (not shown) is fully coated, and thereby increasing a solid solubility and a diffusion speed of a dopant in the locally heated areas. In this case, the locally heated areas may form the contact layers 100c doped at a high concentration, and the remaining unheated areas may form the window layers 100w doped at a low concentration.

More specifically, the contact layers 100c and the window layers 100w may be formed by performing a series of processes such as pre-deposition, drive-in, post-deposition, and local heating. A thick doping material layer (not shown) is formed on the semiconductor substrate 100 by performing two deposition processes, i.e., the pre-deposition and post-deposition processes.

In the drive-in process, thermal processing is performed at a high temperature to diffuse a dopant of the doping material layer into the semiconductor substrate 100. In the local heating process, the contact layers 100c and the window layers 100w having different doping levels are formed by locally heating some selected areas of the semiconductor substrate 100.

Since two deposition processes, i.e., the pre-deposition and post-deposition processes, are performed, a thick doping material layer (not shown) may be formed on the semiconductor substrate 100 and a doping level of the contact layers 100c may be increased to obtain a high open-circuit voltage. Also, a contact resistance between the contact layers 100c and the first electrodes 110 may be reduced.

In particular, since two deposition processes, i.e., the pre-deposition and post-deposition processes, are performed under different process conditions before and after the drive-in process, a doping level may be increased while a conventional recombination loss or a carrier lifetime reduction caused by an increase in a doping level may be avoided. More specifically, since a higher concentration and a shorter process time are applied to the post-deposition process than to the pre-deposition process, a concentration gradient capable of allowing a dopant to be easily diffused may be formed, a junction depth of p-n junction for charge-separating carriers generated by light may be maintained to be low even when a doping level of the contact layers 100c is increased, and a dopant may be prevented from being excessively concentrated on a surface of the semiconductor substrate 100.

The above effects will now be described in detail in comparison to Comparative Examples 1 and 2.

In Comparative Example 1, a thick doping material layer is formed by performing deposition once to obtain a high doping concentration. In Comparative Example 1, a surface concentration of the semiconductor substrate 100 is excessively increased and, since a dopant is excessively concentrated on a surface of the semiconductor substrate 100, a surface recombination speed is increased and a lifetime of carriers is reduced. Also, in Comparative Example 1, a junction depth of p-n junction for charge-separating carriers generated by light is increased and thus carrier collection efficiency is reduced. Consequently, an open-circuit voltage and a short-circuit current are reduced, and a fill factor and a transformation efficiency are reduced.

In Comparative Example 2, instead of forming a doping material layer to be thick, a high-power laser is irradiated onto the contact layers 100c so as to increase a solid solubility of a dopant, and to promote diffusion of the dopant into the irradiated areas. That is, in Comparative Example 2, since the solid solubility of the dopant is further increased and the diffusion of the dopant is promoted by irradiating a high-power laser onto selected areas of the semiconductor substrate 100 on which the doping material layer is formed (i.e., the contact layers 100c), the contact layers 100c may be formed at a high concentration even without forming a thick doping material layer. However, in Comparative Example 2, since the high-power laser damages a surface of the semiconductor substrate 100, a resistance of irradiated areas is increased, a surface recombination loss is increases, and thus a fill factor is reduced.

According to an embodiment of the present invention, since a higher concentration and a shorter process time are applied to the post-deposition process than to the pre-deposition process, a doping concentration of a selective emitter (the contact layers 100c) may be increased, and a junction depth and a surface recombination speed may be reduced.

In the local heating process after the pre-deposition and post-deposition processes, since selected areas (the contact layers 100c) on the semiconductor substrate 100 that is doped at a uniform concentration are locally heated, the window layers 100w and the contact layers 100c having different doping levels may be formed. For example, a solid solubility and a diffusion speed are increased on laser irradiated areas, a dopant of a doping material layer (not shown) is rapidly diffused into the laser irradiated areas, and thus a doping level is increased. The laser irradiated areas form the contact layers 100c doped at a high concentration, and laser unirradiated areas form the window layers 100w doped at a low concentration.

The output of the laser may be set within a range capable of sufficiently promoting diffusion of a dopant into irradiated areas and not causing damage due to irradiation of the laser. If the output of the laser is set to be excessively high, the irradiated areas are damaged and, since a resistance is increased on the damaged parts, a serial resistance is increased and a fill factor is reduced.

The first electrodes 110 are formed on the contact layers 100c. The first electrodes 110 serve to externally output charge-separated carriers formed by the p-n junction.

The first electrodes 110 are formed in a pattern of stripes extending in one direction along a direction of outputting photocurrents. The first electrodes 110 may be formed of a metallic material such as silver (Ag), aluminum (Al), copper (Cu), or nickel (Ni), and may be screen-printed on the contact layers 100c by coating, drying, and firing an electrode paste. Since the first electrodes 110 contacts the contact layers 100c doped at a high concentration, a contact resistance between the contact layers 100c and the first electrodes 110 may be reduced.

Second electrodes 120 are formed on a second surface S2 of the semiconductor substrate 100. For example, the second electrodes 120 may be screen-printed on the semiconductor substrate 100, and may contact a base for collecting a plurality of carriers.

Meanwhile, an antireflective layer 115 and a back surface field (BSF) layer 125 are respectively formed on the first and second surfaces S1 and S2 of the semiconductor substrate 100. The antireflective layer 115 is formed to reduce reflectance of incident light by using destructive interference, and to increase selectivity of certain wavelength areas.

The antireflective layer 115 may be formed as a monolayer such as a silicon oxide (e.g., SiO₂) layer or a silicon nitride (e.g., Si₃N₄) layer, or a multilayer thereof, and may be formed by using, for example, a thermal oxidation method or a chemical vapor deposition (CVD) method.

The BSF layer 125 may be formed as a highly-doped layer having the same conductivity type as that of the semiconductor substrate 100, and may form a BSF by using high concentration/low concentration junction in order to suppress surface recombination of carriers. For example, the BSF layer 125 may be formed as a highly-doped p+ layer on the p-type semiconductor substrate 100.

Meanwhile, the antireflective layer 115 and the BSF layer 125 may have a passivation function for reducing a surface recombination loss. For example, the antireflective layer 115 and the BSF layer 125 may function as passivation layers of the first and second surfaces S1 and S2 of the semiconductor substrate 100.

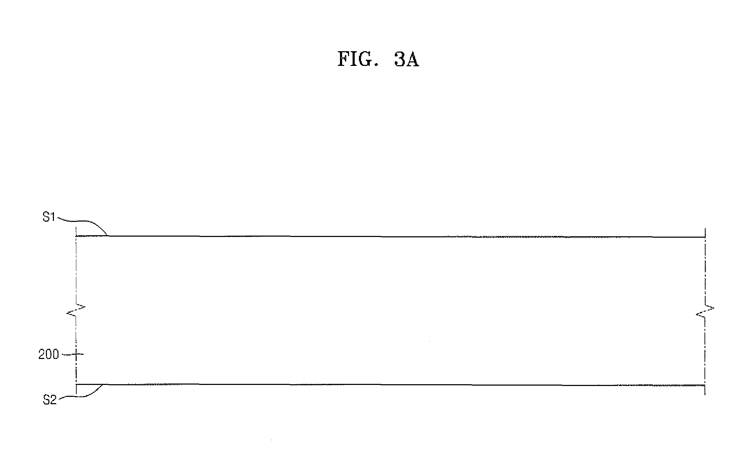

A method of manufacturing a photoelectric device, according to an embodiment of the present invention, will now be described with reference to FIGS. 3A through 3M.

Initially, as illustrated in FIG. 3A, a semiconductor substrate 200 is prepared. For example, the semiconductor substrate 200 may be prepared as a p-type crystalline silicon wafer. For example, a cleaning process may be performed by using an acidic or alkaline solution to remove physical or chemical impurities from a surface of the semiconductor substrate 200.

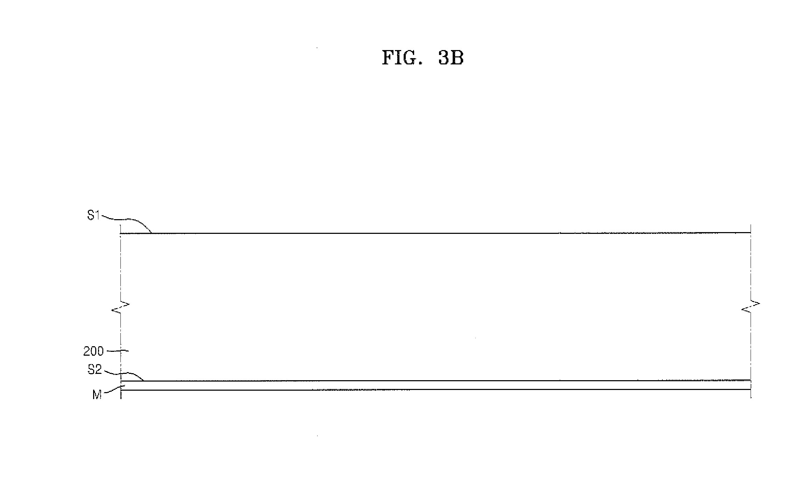

Then, as illustrated in FIG. 3B, a mask layer M is formed to cover a second surface S2 of the semiconductor substrate 200. As will be described below, the mask layer M functions as an etching mask when surface texturing is performed on a first surface S1 of the semiconductor substrate 200, and may be formed of a material that is resistant to a texturing etchant. For example, the mask layer M may be formed as a silicon oxide (e.g., SiO₂) layer or a silicon nitride (e.g., Si₃N₄) layer. The mask layer M may be formed by growing an oxide layer based on a thermal oxidation method, or by depositing an oxide layer or a nitride layer based on a CVD method.

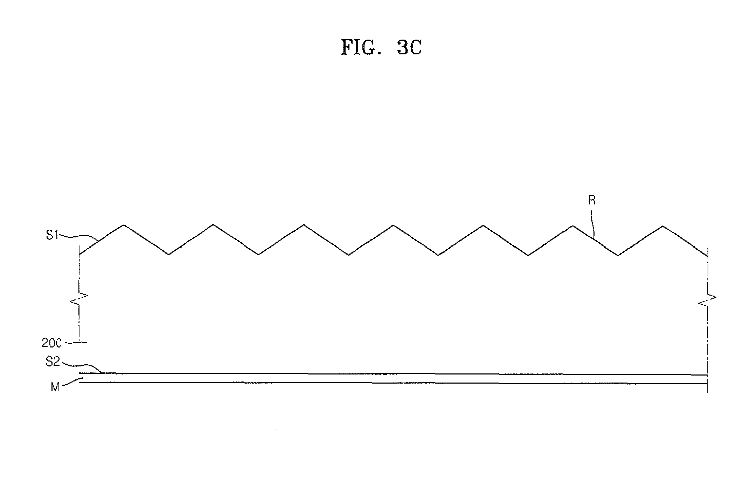

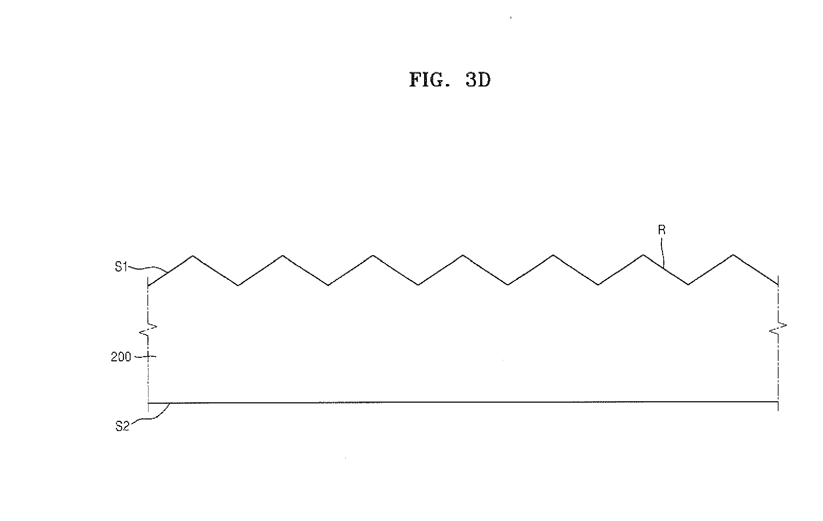

Then, as illustrated in FIG. 3C, surface texturing is performed on the first surface S1 of the semiconductor substrate 200. For example, anisotropic etching is performed on the semiconductor substrate 200 by using an alkaline solution, e.g., KOH or NaOH, as an etchant, and a texture structure R having a roughness pattern may be formed on the first surface S1 of the semiconductor substrate 200. In this case, the second surface S2 of the semiconductor substrate 200, which is covered by the mask layer M, is protected from being etched. As illustrated in FIG. 3D, the mask layer M that is no longer necessary may be removed.

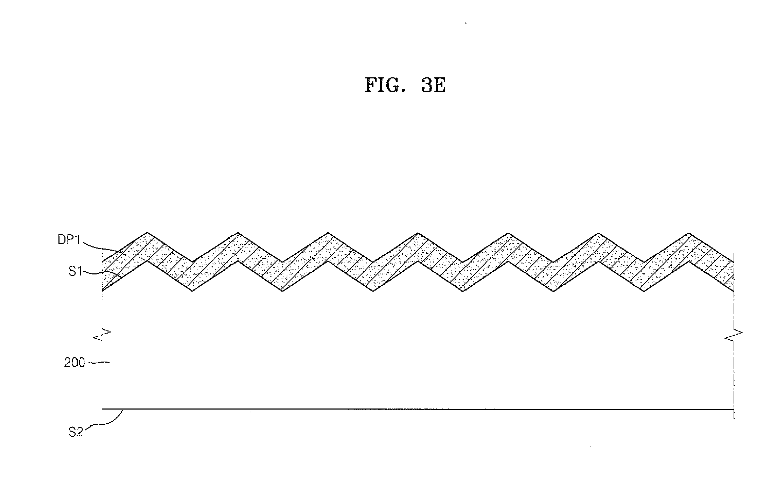

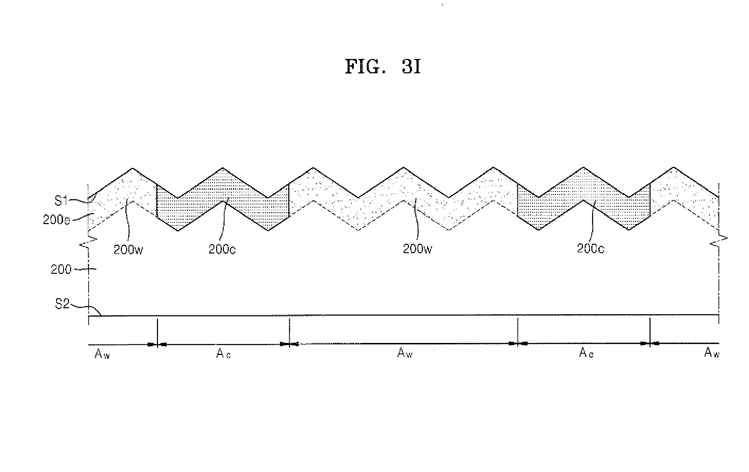

Then, a series of processes illustrated in FIGS. 3E through 3I are performed. As such, as illustrated in FIG. 3I, contact layers 200c and window layers 200w are formed in the first surface S1 of the semiconductor substrate 200. The contact layers 200c and the window layers 200w may be formed by performing a series of processes such as pre-deposition, drive-in, post-deposition, and local heating. These processes will now be described in detail.

Initially, as illustrated in FIG. 3E, the pre-deposition process is performed to form a first doping material layer DP1 on the first surface S1 of the semiconductor substrate 200. In the pre-deposition process, the first doping material layer DP1 may be formed as a p-type or n-type layer. For example, an n-type first doping material layer DP1 having a conductivity type inverse to that of a p-type semiconductor substrate 200 may be formed. In the pre-deposition process, a diffusion system using a diffusion tube may be applied.

More specifically, in the pre-deposition process, as a doping source, phosphorus oxychloride (POCl₃) is applied onto the semiconductor substrate 200 in the diffusion tube by using a carrier gas in which nitrogen and oxygen are mixed. In this case, POCl₃ may react with oxygen and may form the first doping material layer DP1 in the form of a P₂O₅ oxide layer.

Before reacting with silicon of the semiconductor substrate 200, the first doping material layer DP1 may be in the form of a P₂O₅ oxide layer. Due to reaction with silicon, a dopant (phosphorus) of the first doping material layer DP1 is diffused into the semiconductor substrate 200, and an oxide grows in the first surface S1 of the semiconductor substrate 200. In this case, the first doping material layer DP1 may be in the form of a glass layer including SiO₂, e.g., a phosphosilicate glass (PSG) layer.

For example, in the pre-deposition process, a concentration of POCl₃ may be selected from a range of about 5% to about 7%. If the doping source has a concentration less than the lower limit (5%), a surface concentration of the semiconductor substrate 200 may not be sufficient and thus a contact resistance with electrodes is increased. If the doping source has a concentration greater than the upper limit (7%), the surface concentration of the semiconductor substrate 200 may be excessively increased and a surface recombination loss is increased. More specifically, the pre-deposition process may be performed at 840°C for 15 minutes by using POCl₃ having a concentration of 5.7% as the doping source.

For reference, in this specification, the concentration of POCl₃ refers to a volume flow rate of POCl₃ in a gas injected into the diffusion tube in which the semiconductor substrate 200 is disposed. For example, POCl₃ having a concentration of 5.7% represents that a volume flow rate of POCl₃ in a total of 17.5 standard litters per minute (slm) (0°C and 1atm) of a gas including 16 slm of nitrogen, 0.5 slm of oxygen, and 1 slm of POCl₃ is 5.7%.

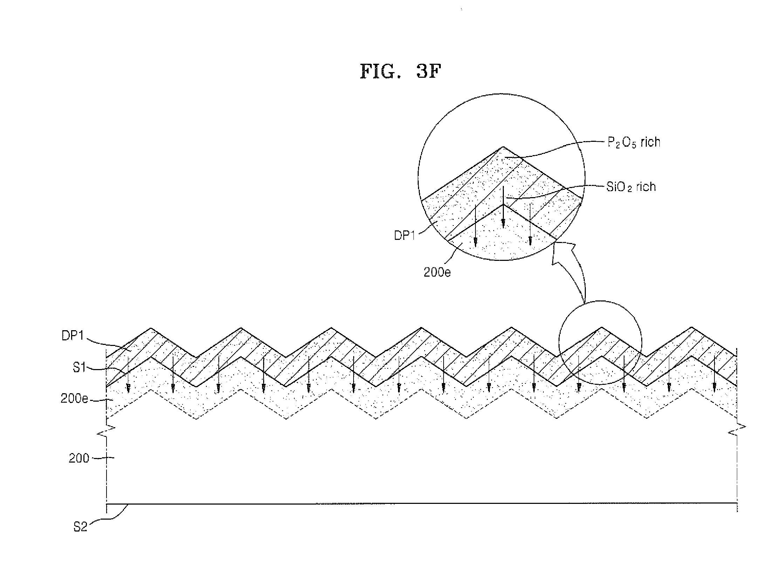

Then, as illustrated in FIG. 3F, the drive-in process is performed to allow the dopant of the first doping material layer DP1 to be rapidly diffused into the semiconductor substrate 200. In the drive-in process, the semiconductor substrate 200 in the diffusion tube is maintained at a high temperature without additionally injecting a doping material. The pre-deposition and drive-in processes may be sequentially performed in the diffusion tube. The drive-in process may be performed at 840°C for 40 minutes and, for example, a nitrogen gas may be injected.

For example, if the dopant (phosphorus) of the first doping material layer DP1 is diffused into the semiconductor substrate 200, an n-type emitter layer 200e is formed in the first surface S1 of the semiconductor substrate 200. In this case, if the dopant (phosphorus, e.g., P₂O₅) is diffused into the semiconductor substrate 200, an oxide grows in the first surface S1 of the semiconductor substrate 200, and the first doping material layer DP1 may have a continuously varying concentration gradient between an upper portion having a relatively high content of P₂O₅ and a lower portion having a relatively high content of SiO₂ along a thickness direction.

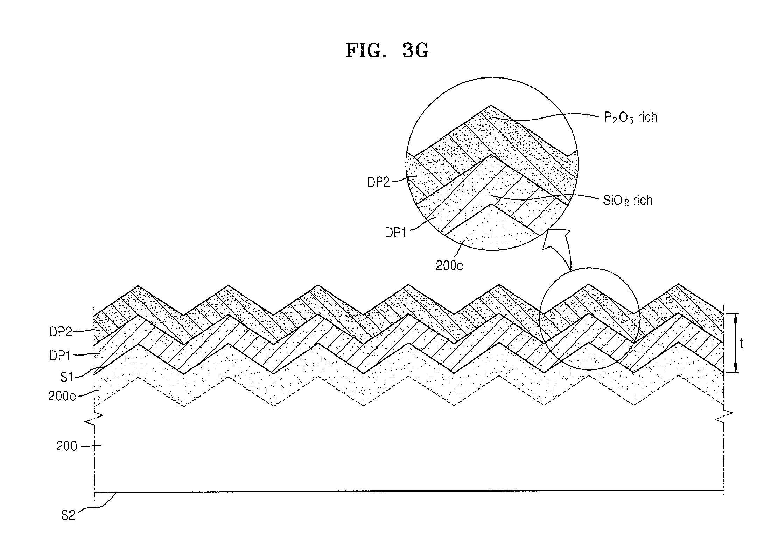

Then, as illustrated in FIG. 3G, the post-deposition process is performed to form a second doping material layer DP2 on the first doping material layer DP1. In the post-deposition process, the second doping material layer DP2 may have the same conductive type as that of the first doping material layer DP1, and a diffusion system using a diffusion tube may be applied.

More specifically, in the post-deposition process, as a doping source, POCl₃ is applied onto the semiconductor substrate 200 in the diffusion tube by using a carrier gas in which nitrogen and oxygen are mixed.

The post-deposition process may be performed under a different process condition from that of the pre-deposition process. That is, a higher concentration of the doping source and a shorter process time are applied to the post-deposition process than to the pre-deposition process. Since a higher concentration is applied to the post-deposition process than to the pre-deposition process, a concentration gradient capable of allowing a dopant to be easily diffused from the second doping material layer DP2 into the semiconductor substrate 200 may be formed. Also, since a shorter process time is applied to the post-deposition process than to the pre-deposition process, increases in a surface concentration and a junction depth of the semiconductor substrate 200 may be suppressed.

That is, when a first concentration Co1 of the doping source and a first process time t1 in the pre-deposition process are compared to a second concentration Co2 of the doping source and a second process time t2 in the post-deposition process, the second concentration Co2 is greater than the first concentration Co1 (Co1 < Co2), and the second process time t2 is less than the first process time t1 (t1 > t2).

For example, a concentration of POCl₃ in the post-deposition process may be selected to be greater than about 10%, and more appropriately, to be greater than about 12%. If the doping source has a concentration lower than the above value, a higher concentration gradient than that of the pre-deposition process, i.e., a concentration gradient capable of easily diffusing the dopant, may not be formed. More specifically, the post-deposition process may be performed at 840°C for 5 minutes by using a POCl₃ solution having a concentration of 12.5% as the doping source.

For example, before the dopant is diffused, the second doping material layer DP2 may be in the form of a P₂O₅ oxide layer. Since the dopant of the second doping material layer DP2 is diffused into the semiconductor substrate 200, an oxide grows in the first surface S1 of the semiconductor substrate 200. In this case, the second doping material layer DP2 may be in the form of a glass layer including SiO₂, e.g., a PSG layer.

For example, the second doping material layer DP2 may form a thick PSG layer together with the first doping material layer DP1 formed in the pre-deposition process. That is, the second doping material layer DP2 may form one PSG layer having a predetermined thickness t together with the first doping material layer DP1. In this case, the PSG layer may have a concentration profile having a relatively high content of SiO₂ near an interface of the semiconductor substrate 200 while having a relatively low content of SiO₂ and a relatively high content of P₂O₅ away from the interface.

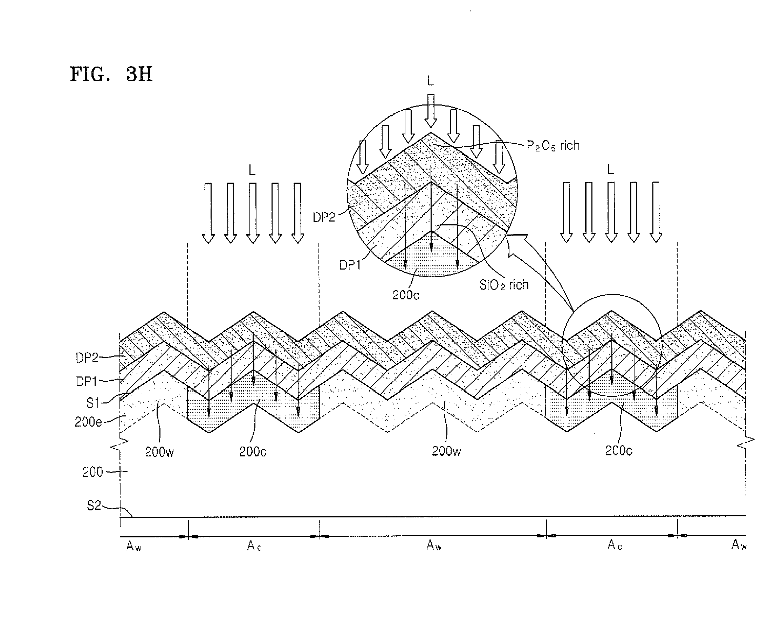

Then, as illustrated in FIG. 3H, the local heating process is performed to locally heating contact areas Ac on the semiconductor substrate 200 where the first and second doping material layers DP1 and DP2 are formed, thereby varying doping levels. In the local heating process, the contact layers 200c are formed at a high concentration by locally heating some areas on the semiconductor substrate 200, and more particularly, the contact areas Ac for forming the first electrodes 210.

If a laser L is irradiated onto the contact areas Ac on the semiconductor substrate 200, a solid solubility and a diffusion speed of the contact areas Ac are increased. That is, the dopant (phosphorus) of the first and second doping material layers DPI and DP2 formed to be thick in the pre-deposition and post-deposition processes is diffused into the contact areas Ac onto which the laser L is irradiated, and a doping concentration is increased.

In this case, the contact layers 200c having a high doping level is formed in the contact areas Ac onto which the laser L is irradiated, and the window layers 200w having a low doping level are formed in window areas Aw onto which the laser L is not irradiated. The irradiated laser L is transmitted without being absorbed into the first and second doping material layers DP1 and DP2 having a high band-gap energy, and is absorbed into the semiconductor substrate 200 to increase a solid solubility and a diffusion speed of the dopant (phosphorus).

According to an embodiment of the present invention, since two deposition processes, i.e., the pre-deposition and post-deposition processes, are performed, when compared to a case when deposition is performed once, the first and second doping material layers DP1 and DP2 may be formed to be thick, and the contact layers 200c may be formed at a high concentration by performing the local heating process. Since a doping concentration of the contact layers 200c is increased, a contact resistance with the first electrodes 710 may be reduced, a serial resistance of photocurrents may be reduced, a high open-circuit voltage may be obtained, and a fill factor may be increased.

Then, as illustrated in FIGS. 3H and 3I, an etch-back process may be performed to remove the first and second doping material layers DP1 and DP2. The first and second doping material layers DP1 and DP2 may be in the form of a PSG layer. Since the first and second doping material layers DP1 and DP2 include precipitates of metallic impurities contained in the semiconductor substrate 200, a gathering effect for removing impurities may be expected by removing the first and second doping material layers DP1 and DP2.

For example, the first and second doping material layers DP1 and DP2 may be etched by using an acidic solution, e.g., a mixed solution of nitric acid (HNO₃), hydrofluoric acid (HF), and acetic acid (CH₃COOH or deionized (DI) water), as an etchant. However, according to another embodiment of the present invention, the first and second doping material layers DP1 and DP2 may not be removed and may be used as a passivation layer.

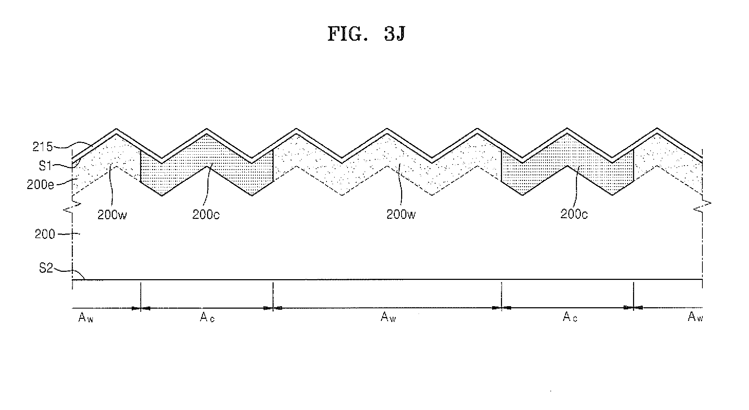

Then, as illustrated in FIG. 3J, an antireflective layer 215 is formed on the first surface S1 of the semiconductor substrate 200. For example, the antireflective layer 215 may be formed as a silicon oxide (e.g., SiO₂) layer, a silicon nitride (e.g., Si₃N₄) layer, or a hydrogenated silicon nitride (SiN:H) layer, and may be formed as a monolayer of a silicon oxide layer, or a multilayer of a silicon oxide layer and a silicon nitride layer having difference refractive indices. The antireflective layer 215 may be formed by using a CVD method.

The antireflective layer 215 may have a passivation function for preventing surface recombination of carriers generated by the semiconductor substrate 200 and thus improving carrier collection efficiency. That is, the antireflective layer 215 may improve carrier collection efficiency by preventing trapping of carriers due to a dangling bond of silicon atoms on a surface of the semiconductor substrate 200.

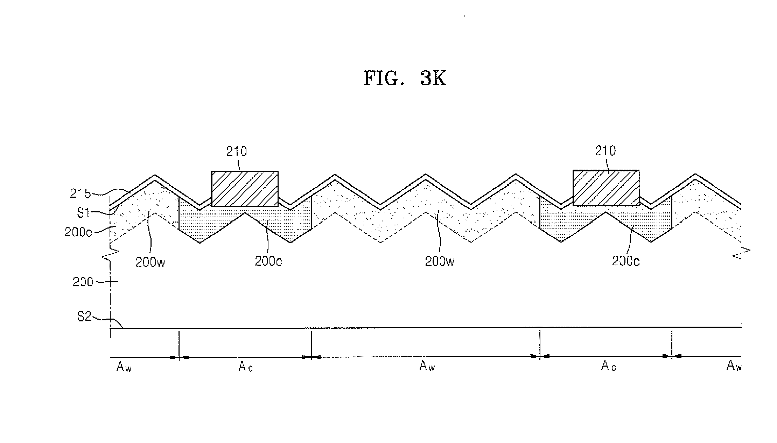

Then, as illustrated in FIG. 3K, the first electrodes 210 are formed on the contact layers 200c. The first electrodes 210 may be formed in a pattern of stripes extending in one direction in parallel along a direction of outputting photocurrents, and may be patterned in consideration of valid incident areas of light.

The first electrodes 210 may include a metallic material such as Ag, Al, Cu, or Ni. For example, an electrode paste (not shown) may be pattern-printed on the contact layers 200c by using a screen printing method, and may be dried and fired. As such, a glass frit component included in the electrode paste may penetrate through the antireflective layer 215 to allow the first electrodes 210 and the contact layers 200c to contact each other.

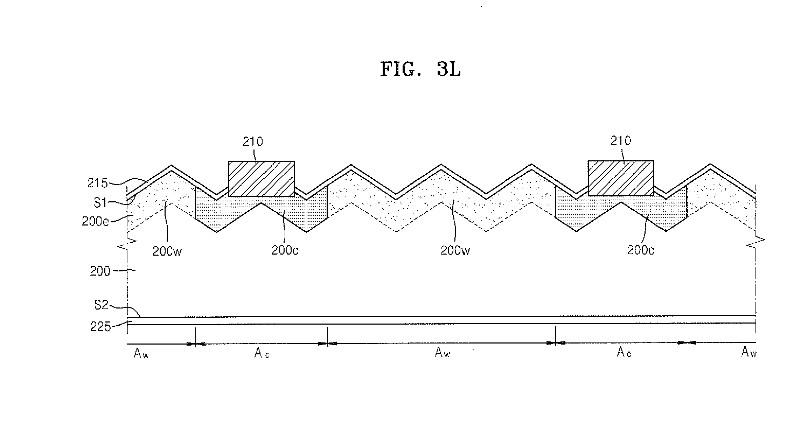

Then, as illustrated in FIG. 3L, a BSF layer 225 is formed on the second surface S2 of the semiconductor substrate 200. For example, the BSF layer 225 may be formed as a highly-doped layer using a dopant having the same conductive type as that of the semiconductor substrate 200. For example, the BSF layer 225 may be formed as a highly-doped p+ layer on the second surface S2 of the semiconductor substrate 200, and may prevent minority carriers (electrons) from moving toward the second surface S2 and being recombined.

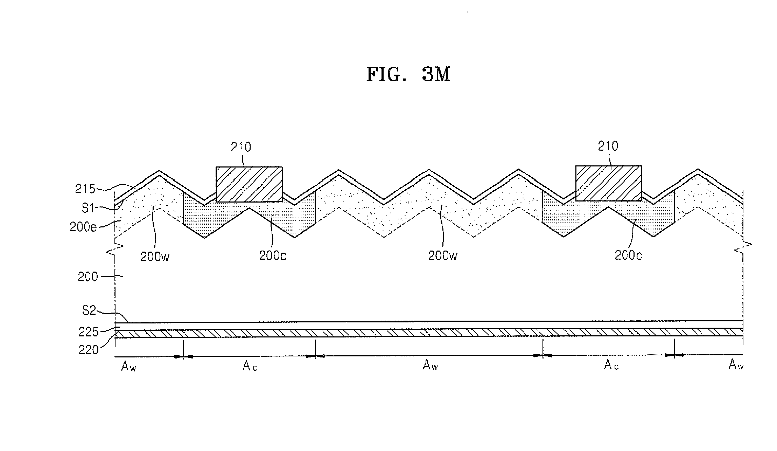

Then, as illustrated in FIG. 3M, second electrodes 220 are formed on the second surface S2 of the semiconductor substrate 200. The second electrodes 220 may be formed of a metallic material such as Ag, Al, Cu, or Ni. The second electrodes 220 may be formed by using a screen printing method or a plating method, and may be formed by, for example, coating, drying, and firing an electrode paste (not shown). The first electrodes 210 on the first surface S1 and the second electrodes 220 on the second surface S2 may be simultaneously formed by co-firing a first electrode paste (not shown) and a second electrode paste (not shown).

Test results regarding characteristics of the photoelectric device according to an embodiment of the present invention are shown in the following table.

| | Case 1 | Case 2 | Case 3 | Case 4 | Present Invention |
|---|---|---|---|---|---|
| Pre-deposition Condition | 840°C, 15min POCl₃ 4,7% | 840°C, 25min POCl₃ 8.7% | 840°C, 15min POCl₃ 8.7% | 840°C, 10min POCl₃ 12.5% | 840°C, 15min POCl₃ 5.7% |
| Drive-in Condition | 840°C, 40min | 830°C, 20min | 840°C, 15min | 840°C, 15min | 840°C, 40min |
| Post-deposition Condition | X | X | X | X | 840°C, 5min, POCl₃ 12.5% |
| Thickness (□) of Doping Material Layer | 245 | 360 | 318 | 270 | 310 |
| Surface Resistance (Ω/□) of Contact Layers | 69 | 50 | 56 | 51 | 49 |
| Surface Resistance (Ω/□) of Window Layers | 110 | 110 | 110 | 110 | 110 |
| Implied open-circuit voltage Voc (mV) | 658 | 648 | 649 | 649 | 660 |

Cases 1 through 4 represent photoelectric devices formed by performing pre-deposition and drive-in processes, and the present invention represents a photoelectric device formed by performing two deposition processes, i.e., the pre-deposition and post-deposition processes, under different process conditions before and after a drive-in process.

In Case 1, the pre-deposition is performed at 840°C for 15 minutes by using POCl₃ having a concentration of 4.7% as a doping source, and then the drive-in process is performed at 840°C for 40 minutes.

Case 2, the pre-deposition is performed at 840°C for 25 minutes by using POCl₃ having a concentration of 8.7% as a doping source, and then the drive-in process is performed at 830°C for 20 minutes.

Case 3, the pre-deposition is performed at 840°C for 15 minutes by using POCl₃ having a concentration of 8.7% as a doping source, and then the drive-in process is performed at 840°C for 15 minutes.

Case 4, the pre-deposition is performed at 840°C for 10 minutes by using POCl₃ having a concentration of 12.5% as a doping source, and then the drive-in process is performed at 840°C for 15 minutes.

In the present invention, the pre-deposition is performed at 840°C for 15 minutes by using POCl₃ having a concentration of 5.7% as a doping source, the drive-in process is performed at 840°C for 40 minutes, and then the post-deposition is performed at 840°C for 5 minutes by using POCl₃ having a concentration of 12.5% as a doping source.

In each of Cases 1 through 4 and the present embodiment of the invention, a thickness of a doping material layer, a surface resistance of contact layers, and an implied open-circuit voltage Voc are measured. In this case, the surface resistance of the contact layers is measured after making a surface resistance of window layers as 110Ω/□ by performing an etch-back process.

When the present embodiment of the invention is compared to Case 1, a thicker doping material layer (PSG layer) is formed in the present embodiment of the invention than in Case 1. If a doping material layer is formed to be relatively thick, the amount of a dopant to be injected may be increased and thus a doping level of the contact layers may be increased.

When the present embodiment of the invention is compared to Cases 2 and 3, a lower surface resistance of the contact layers is obtained in the present embodiment of the invention than in Cases 2 and 3 where relatively thicker doping material layers are formed in comparison to the present embodiment of the invention. Instead of merely thickening a doping material layer, if a concentration gradient capable of allowing a dopant to be easily diffused is formed by applying a doping source having a relatively high concentration to the post-deposition than to the pre-deposition as in the present embodiment of the invention, a doping level may be effectively increased and thus the surface resistance of the contact layers may be lowered.

When the present embodiment of the invention and Case 4 using the same doping source (12.5%, POCl₃) are compared, a lower surface resistance of the contact layers is obtained in the present embodiment of the invention than in Case 4. Instead of merely increasing a concentration of a doping source, if a concentration gradient capable of allowing a dopant to be easily diffused is formed by applying a doping source having a relatively high concentration to the post-deposition than to the pre-deposition as in the present embodiment of the invention, a doping level may be effectively increased and thus the surface resistance of the contact layers may be lowered.

With regard to the implied open-circuit voltage Vocs in Cases 1 through 4 and the present embodiment of the invention, the highest implied open-circuit voltage Voc is obtained in the present embodiment of the invention. The implied open-circuit voltage Voc reflects a recombination loss of carriers generated by light, and is reduced if the recombination loss is increased. More specifically, the implied open-circuit voltage Voc is measured by using photo conductance decay (PCD), is calculated by using a measured lifetime of carriers, and is used to predict an open-circuit voltage Voc of a produced photoelectric device. If the lifetime of carriers is long, the implied open-circuit voltage Voc is increased.

The highest implied open-circuit voltage Voc obtained in the present embodiment of the invention may be regarded as a result of suppressing a surface concentration of a semiconductor substrate, reducing a surface recombination loss and a junction depth, and improving carrier collection efficiency by a doping source having a relatively low concentration to the pre-deposition process directly performed on a surface of the semiconductor substrate, and applying a shorter process time to the post-deposition process than to the pre-deposition.

In Cases 2 through 4 using higher concentrations of POCl₃ in the pre-deposition process than Case 1, although low surface resistances are obtained in comparison to Case 1, due to increased in a junction depth and a recombination loss, the implied open-circuit voltages Voc in Cases 2 through 4 are lower than that in Case 1.

Meanwhile, although two deposition processes, i.e., the pre-deposition and post-deposition processes, are performed under different process conditions, according to an embodiment of the present invention, three or more deposition processes may be performed wherein a higher concentration is applied to a subsequent deposition process than to a previous deposition process so as to form a concentration gradient capable of allowing a dopant to be easily diffused, and as a shorter process time is applied to a subsequent deposition process than to a previous deposition process so as to suppress excessive increases in a junction depth and a surface concentration.

For example, if three or more deposition processes are performed, a series of processes such as primary deposition, drive-in, secondary deposition, drive-in, and tertiary deposition may be performed, and a concentration Co1 of a doping source in the primary deposition process, a concentration Co2 of the doping source in the secondary deposition process, and a concentration Co3 of the doping source in the tertiary deposition process may satisfy Co1 < Co2 < Co3. Also, a process time t1 in the primary deposition process, a process time t2 in the secondary deposition process, and a process time t3 in the tertiary deposition process may satisfy t1 > t2 > t3.

It should be understood that the embodiments described herein should be considered in a descriptive sense only and not for purposes of limitation. Descriptions of features or aspects within each embodiment should typically be considered as available for other similar features or aspects in other embodiments.

## Claims

1. A method of manufacturing a photoelectric device comprising:
providing a substrate (200);
applying a first doping source material to a first surface of the substrate (200), so as to form a first doping material layer (DP1) over the said first surface;
applying a drive-in process to cause a dopant from the first doping material layer (DP1) to diffuse into the substrate (200); and
applying a second doping source material to the said first surface of the substrate (200), so as to form a second doping material layer (DP2) over the said first doping material layer (DP1).

2. A method according to claim 1, wherein a dopant from the first doping source material is diffused into the substrate (200) when the first doping source material is applied to the substrate (200).

3. A method according to claim 1 or 2, wherein a dopant from the second doping source material is diffused into the substrate (200) when the second doping source material is applied to the substrate (200).

4. A method according to any preceding claim, comprising selectively heating a plurality of predetermined areas (Ac) of the semiconductor substrate (200) to cause dopant from at least one of the first doping material layer (DP1) and the second doping material layer (DP2) to diffuse into the said predetermined areas (Ac).

5. A method according to claim 4, wherein the said heating is effected via a laser.

6. A method according to claim 4 or 5, comprising installing an electrode (110) on at least one of the predetermined areas (Ac).

7. A method according to any preceding claim, wherein the first doping source material is contained within a first carrier medium and the second doping source material is contained within a second carrier, medium and the concentration of the first doping source material within the first carrier medium is lower than the concentration of the second doping source material within the second carrier medium.

8. A method according to claim 7, wherein the concentration of the first doping source material in the first carrier medium is from 5% to 7%.

9. A method according to claim 7 or 8, wherein the concentration of the second doping source material in the second carrier medium is 10% or greater.

10. A method according to claim 8, wherein the concentration of the second doping source material in the second carrier medium is 12% or greater.

11. A method according to one of claims 7 to 10, wherein the carrier medium is a gas.

12. A method according to any preceding claim, wherein the first doping source material is applied to the substrate (200) for a greater period of time than the second doping source material is applied to the substrate (200).

13. A method according to any preceding claim, wherein the first doping source material is the same as the second doping source material.

14. A method according to claim 13, wherein the said first doping source material and the second doping source material each comprise POCl₃.

15. A method according to any preceding claim, comprising applying a third doping source material to the said first surface of the substrate (200), so as to form a third doping material layer over the said second doping material layer (DP2).

16. A method according to claim 15, wherein the third doping source material is contained within a third carrier medium and the concentration of the third doping source material within the third carrier medium is higher than the concentration of the second doping source material within the second carrier medium.

17. A method according to claim 15 or 16, wherein the third doping source material is applied to the substrate (200) for a shorter period of time than the second doping source material is applied to the substrate (200).
